# EUROPEAN PATENT APPLICATION

(11) **EP 2 945 247 A1**
(43) Date of publication of application: **18.11.2015**
(21) Application number: 15165189.0
(22) Date of filing: 27.04.2015
(51) Int. Cl.: H02J 3/36

(54) **APPARATUS AND METHOD FOR VERIFYING LIGHTNING ARRESTER OF HIGH VOLTAGE DIRECT CURRENT TRANSMISSION SYSTEM**

(30) Priority: 13.05.2014 KR 20140057378
(71) Applicant: LSIS Co., Ltd., Anyang-si, Gyeonggi-do 431-848 (KR)
(72) Inventor: Choi, Yong Kil, 431-848 Anyang-si, Gyeonggi-do (KR); Choi, Ho Seok, 431-848 Anyang-si, Gyeonggi-do (KR)
(74) Representative: Lang, Johannes

(57) **Abstract**

Provided is an apparatus for an insulation design. The apparatus for the insulation design, which performs the insulation design of a high voltage direct current (HVDC) transmission system, includes an insulation design part generating an insulation model of the HVDC transmission system, a lighting arrester modeling part generating a lighting arrester model that satisfies a specification of a lighting arrester selected for the lighting arrester within the insulation model of the HVDC transmission system, a simulation test part performing a simulation test of the lighting arrester model in the insulation model of the HVDC transmission system to output a lighting arrester simulation test result, a comparison part acquiring a lighting arrester property test result and comparing the lighting arrester property test result to the lighting arrester simulation test result, and a result output part outputting a verification result of the lighting arrester on the basis of the comparison between the lighting arrester property test result and the lighting arrester simulation test result.

## Description

### BACKGROUND

The present disclosure relates to a high voltage direct current transmission (HVDC) system. Particularly, the present disclosure relates to a method for verifying a lighting arrester of an HVDC system.

The HVDC system may convey electricity to a far distance through high voltage DC.

In general, the HVDC system may transmit electricity by using an overhead line or submarine cable.

The HVDC system is being widely used due to advantages such as less investment costs, unlimited cable length, and less power transmission loss.

Since the HVDC system conveys electricity through the high voltage DC, it may be necessary to utilize a verified lighting arrester. However, the verification of the lighting arrester has to be performed again whenever the HVDC transmission system changes, and a design value of the HVDC transmission system may not be reflected to the verification of the lighting arrester. Particularly, when being applied to an actual system, there is a cumbersome process for redesigning the lighting arrester for each section and voltage fluctuation.

### SUMMARY

Embodiments provide an apparatus and method for verifying a lighting arrester, which provides convenience of the lighting arrester and removes inconvenience in verification of the lighting arrester.

In one embodiment, an apparatus for an insulation design, which performs the insulation design of a high voltage direct current (HVDC) transmission system, includes: an insulation design part generating an insulation model of the HVDC transmission system; a lighting arrester modeling part generating a lighting arrester model that satisfies a specification of a lighting arrester selected for the lighting arrester within the insulation model of the HVDC transmission system; a simulation test part performing a simulation test of the lighting arrester model in the insulation model of the HVDC transmission system to output a lighting arrester simulation test result; a comparison part acquiring a lighting arrester property test result and comparing the lighting arrester property test result to the lighting arrester simulation test result; and a result output part outputting a verification result of the lighting arrester on the basis of the comparison between the lighting arrester property test result and the lighting arrester simulation test result.

The details of one or more embodiments are set forth in the accompanying drawings and the description below. Other features will be apparent from the description and drawings, and from the claims.

### BRIEF DESCRIPTION OF THE DRAWINGS

Fig. 1 is a view of a high voltage direct current (HVDC) transmission system according to an embodiment.
Fig. 2 is a view of a monopolar-type HVDC transmission system according to an embodiment.
Fig. 3 is a view of a bipolar-type HVDC transmission system according to an embodiment.
Fig. 4 is a view illustrating connection between a transformer and a three-phase valve bridge according to an embodiment.
Fig. 5 is a block diagram illustrating an apparatus for an insulation design of the HVDC transmission system according to an embodiment.
Fig. 6 is a flowchart illustrating an operation method of the insulation design apparatus of the HVDC transmission system according to an embodiment.
Fig. 7 is a block diagram of an apparatus for verifying a lighting arrester of the HVDC transmission system according to an embodiment.
Fig. 8 is a flowchart illustrating an operation method of the apparatus for verifying the lighting arrester of the HVDC transmission system according to an embodiment.

### DETAILED DESCRIPTION OF THE EMBODIMENTS

Reference will now be made in detail to the embodiments of the present disclosure, examples of which are illustrated in the accompanying drawings.

An electric device for an electric vehicle according to an embodiment will be described in detail with reference to the accompanying drawings. The invention may, however, be embodied in many different forms and should not be construed as being limited to the embodiments set forth herein; rather, that alternate embodiments included in other retrogressive inventions or falling within the spirit and scope of the present disclosure can easily be derived through adding, altering, and changing, and will fully convey the concept of the invention to those skilled in the art.

Hereinafter, embodiments of the present disclosure will be described in more detail with reference to the accompanying drawings. Furthermore, terms, such as a "part", a "module" ad a "unit", are used for convenience of description, and they do not have different meanings or functions in themselves.

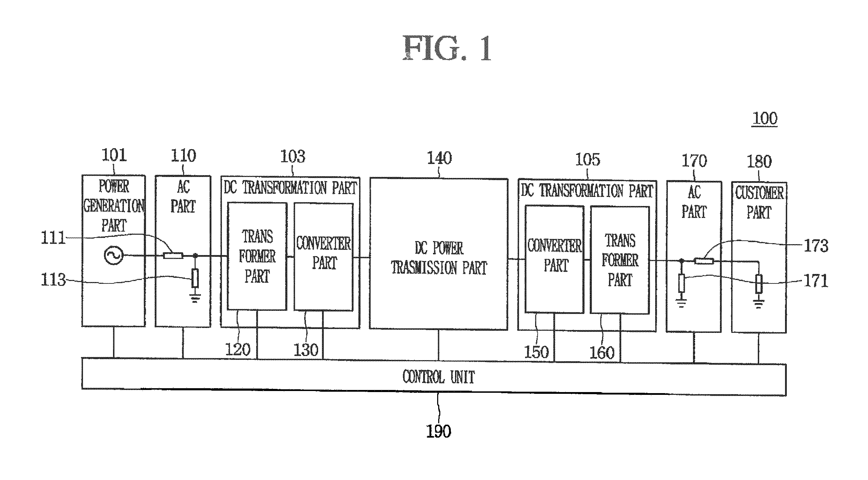

Fig. 1 is a view of a high voltage direct current (HVDC) transmission system according to an embodiment.

Referring to Fig. 1, an HVDC transmission system 100 according to an embodiment includes a power generation part 101, a transmission-side alternating current (AC) part 110, a transmission-side transformation part 103, a direct current (DC) power transmission part 140, a customer-side DC transformation part 105, a customer-side AC part 170, a customer part 180, and a control part 190. The transmission-side DC transformation part 103 includes a transmission-side transformer part 120, and a transmission-side AC-DC converter part 130. The customer-side DC transformation part 105 includes a customer-side DC-AC converter part 150, and a customer-side transformer part 160.

The power generation part 101 generates a three-phase AC power. The power generation part 101 may include a plurality of power generating plants.

The transmission-side AC part 110 transmits the three-phase AC power generated by the generation part 101 to a DC power transformation substation including the transmission-side transformer part 120 and the transmission-side AC-DC converter part 130.

The transmission-side transformer part 110 isolates the transmission-side AC part 110 from the transmission-side AC-DC converter part 130 and the DC power transmission part 140.

The transmission-side AC-DC converter part 130 converts the three-phase AC power corresponding to an output of the transmission-side transformer part 120 into a DC power.

The DC power transmission part 140 transfers the transmission-side DC power to a customer-side.

The customer-side DC-AC converter part 150 converts the DC power transmitted by the DC power transmission part 140 into a three-phase AC power.

The customer-side transformer part 160 isolates the customer-side AC part 170 from the customer-side DC-AC converter part 150 and the DC power transmission part 140.

The customer-side AC part 170 provides the three-phase AC power corresponding to an output of the customer-side transformer part 160 to the customer part 180.

The control part 190 controls at least one of the power generation part 101, the transmission-side AC part 110, the transmission-side DC transformation part 103, the DC power transmission part 140, the customer-side DC transformation part 105, the customer-side AC part 170, the customer part 180, the transmission-side AC-DC converter part 130, and the customer-side DC-AC converter part 150. Particularly, the control part 190 may control turn-on and turn-off timings of a plurality of valves within the transmission-side AC-DC converter part 130 and the customer-side DC-AC converter part 150. Here, each of the valves may be a thyristor or an insulated gate bipolar transistor (IGBT).

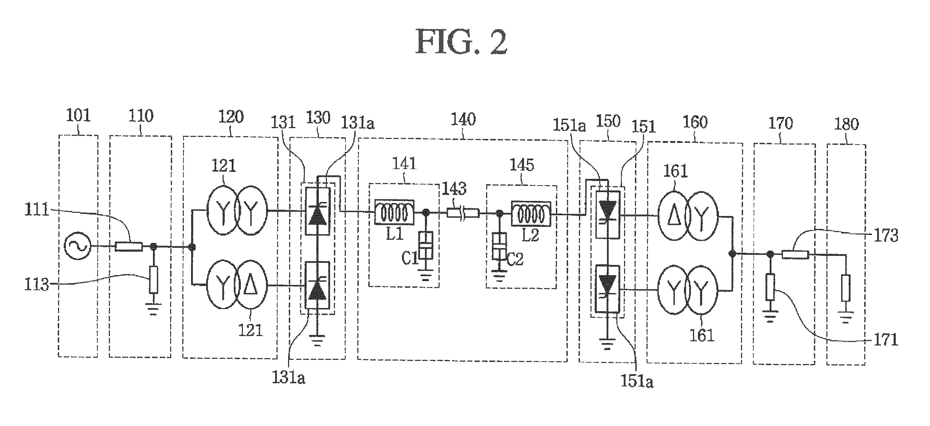

Fig. 2 is a view of a monopolar-type HVDC transmission system according to an embodiment.

Particularly, Fig. 2 illustrates a system that transmits a DC power having a single pole. Hereinafter, it is assumed that the single pole is a positive pole, but is not limited thereto.

The transmission-side AC part 110 includes an AC transmission line 111 and an AC filter 113.

The AC power transmission line 111 transmits the three-phase AC power generated by the generation part 101 to the transmission-side DC transformation part 103.

The AC filter 113 removes remaining frequency components except for a frequency component that is used by the DC transformation part 103 from the transferred three-phase AC power.

The transmission-side transformer part 120 includes at least one transformer 121 for the positive pole. For the positive pole, the transmission-side AC-DC converter part 130 includes an AC-positive pole DC converter 131 that generates a positive pole DC power, and the AC-positive pole DC converter 131 includes at least one three-phase valve bridge 131a corresponding to the at least one transformer 121.

When one three-phase valve bridge 131a is used for the positive pole, the AC-positive pole DC converter 131 may generate a positive pole DC power having 6 pulses by using the AC power. Here, a primary coil and a secondary coil of one transformer 121 may have Y-Y connection or Y-Δ connection.

When two three-phase valve bridges 131a are used, the AC-positive pole DC converter 131 may generate a positive pole DC power having 12 pulses by using the AC power. Here, a primary coil and a secondary coil of one of the two transformers 121 may have Y-Y connection, and a primary coil and a secondary coil of the other of the two transformers 121 may have Y-Δ connection.

When three three-phase valve bridges 131a are used, the AC-positive pole DC converter 131 may generate a positive pole DC power having 18 pulses by using the AC power. The more the number of pulses of the positive pole DC power increases, the more a filter price may decrease.

The DC power transmission part 140 includes a transmission-side positive pole DC filter 141, a positive pole DC power transmission line 143, and a customer-side positive pole DC filter 145.

The transmission-side positive pole DC filter 141 includes an inductor L1 and a capacitor C1 and performs DC filtering on the positive pole DC power output by the AC-positive pole DC converter 131.

The positive pole DC power transmission line 143 has one DC line for transmitting the positive pole DC power, and the earth may be used as a current feedback path. At least one switch may be disposed on the DC line.

The customer-side negative pole DC filter 145 includes an inductor L2 and a capacitor C2 and performs DC filtering on the positive pole DC power transferred through the positive pole DC power transmission line 143.

The customer-side DC-AC converter part 150 includes a positive pole DC-AC converter 151 and at least one three-phase valve bridge 151a.

The customer-side transformer part 160 includes, for the positive pole, at least one transformer 161 corresponding to at least one three-phase valve bridge 151a.

When one three-phase valve bridge 151a is used, the positive pole DC-AC converter 151 may generate an AC power having 6 pulses by using the positive pole DC power. Here, a primary coil and a secondary coil of one transformer 161 may have Y-Y connection or Y-Δ connection.

When two three-phase valve bridges 151a are used, the positive pole DC-AC converter 151 may generate an AC power having 12 pulses by using the positive pole DC power. Here, a primary coil and a secondary coil of one of the two transformers 161 may have Y-Y connection, and a primary coil and a secondary coil of the other of the two transformers 161 may have Y-Δ connection.

When three three-phase valve bridges 151a are used, the positive pole DC-AC converter 151 may generate an AC power having 18 pulses by using the positive pole DC power. The more the number of pulses of the AC power increases, the more the filter price may decrease.

The customer-side AC part 170 includes an AC filter 171 and an AC power transmission line 173.

The AC filter 171 removes remaining frequency components except for a frequency component (for example, 60Hz) used by the customer part 180 from the AC power generated by the customer-side DC transformation part 105.

The AC power transmission line 173 transmits the filtered AC power to the customer part 180.

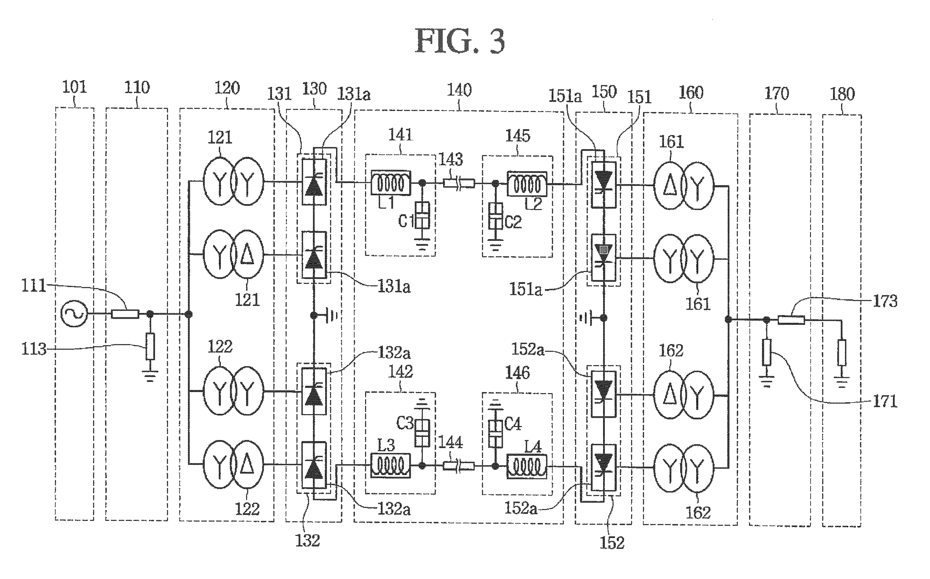

Fig. 3 is a view of a bipolar-type HVDC transmission system according to an embodiment.

Particularly, Fig. 3 illustrates a system that transmits a DC power having two poles. Hereinafter, it is assumed that the two poles are a positive pole and a negative pole, but is not limited thereto.

The transmission-side AC part 110 includes an AC transmission line 111 and an AC filter 113.

The AC power transmission line 111 transmits the three-phase AC power generated by the generation part 101 to the transmission-side transformation part 103.

The AC filter 113 removes remaining frequency components except for a frequency component used by the transformation part 103 from the transferred three-phase AC power.

The transmission-side transformer part 120 includes at least one transformer 121 for the positive pole and at least one transformer 122 for the negative pole. The transmission-side AC-DC converter part 130 includes an AC-positive pole DC converter 131 that generates a positive pole DC power and an AC-negative pole DC converter 132 that generates a negative pole DC power. The AC-positive pole DC converter 131 includes at least one three-phase valve bridge 131a corresponding to the at least one transformer 121 for the positive pole. The AC-negative pole DC converter 132 includes at least one three-phase valve bridge 132a corresponding to the at least one transformer 122 for the negative pole.

When one three-phase valve bridge 131a is used for the positive pole, the AC-positive pole DC converter 131 may generate a positive pole DC power having 6 pulses by using the AC power. Here, a primary coil and a secondary coil of one transformer 121 may have Y-Y connection or Y-Δ connection.

When two three-phase valve bridges 131a are used for the positive pole, the AC-positive pole DC converter 131 may generate a positive pole DC power having 12 pulses by using the AC power. Here, a primary coil and a secondary coil of one of the two transformers 121 may have Y-Y connection, and a primary coil and a secondary coil of the other of the two transformers 121 may have Y-Δ connection.

When three three-phase valve bridges 131a are used for the positive pole, the AC-positive pole DC converter 131 may generate a positive pole DC power having 18 pulses by using the AC power. The more the number of pulses of the positive pole DC power increases, the more the filter price may decrease.

When one three-phase valve bridge 132a is used for the negative pole, the AC-negative pole DC converter 132 may generate a negative pole DC power having 6 pulses. Here, a primary coil and a secondary coil of one transformer 122 may have Y-Y connection or Y-Δ connection.

When two three-phase valve bridges 132a are used for the negative pole, the AC-negative pole DC converter 132 may generate a negative pole DC power having 12 pulses. Here, a primary coil and a secondary coil of one of the two transformers 122 may have Y-Y connection, and a primary coil and a secondary coil of the other of the two transformers 122 may have Y-Δ connection.

When three three-phase valve bridges 132a are used for the negative pole, the AC-negative pole DC converter 132 may generate a negative pole DC power having 18 pulses. The more the number of pulses of the negative pole DC power increases, the more the filter price may decrease.

The DC power transmission part 140 includes a transmission-side positive pole DC filter 141, a transmission-side negative pole DC filter 142, a positive pole DC power transmission line 143, a negative pole DC power transmission line 144, a customer-side positive pole DC filter 145, and a customer-side negative pole DC filter 146.

The transmission-side positive pole DC filter 141 includes an inductor L1 and a capacitor C1 and performs DC filtering on the positive pole DC power output by the AC-positive pole DC converter 131.

The transmission-side negative pole DC filter 142 includes an inductor L3 and a capacitor C3 and performs DC filtering on the negative pole DC power output by the AC-negative pole DC converter 132.

The positive pole DC power transmission line 143 has one DC line for transmitting the negative pole DC power, and the earth may be used as a current feedback path. At least one switch may be disposed on the DC line.

The negative pole DC power transmission line 144 has one DC line for transmitting the negative pole DC power, and the earth may be used as a current feedback path. At least one switch may be disposed on the DC line.

The customer-side negative pole DC filter 145 includes an inductor L2 and a capacitor C2 and performs DC filtering on the positive pole DC power transferred through the positive pole DC power transmission line 143.

The customer-side negative pole DC filter 146 includes an inductor L4 and a capacitor C4 and performs DC filtering on the negative pole DC power transferred through the negative pole DC power transmission line 144.

The customer-side DC-AC converter part 150 includes a positive pole DC-AC converter 151 and a negative pole DC-AC converter 152. The positive pole DC-AC converter 151 includes at least one three-phase valve bridge 151a, and the negative pole DC-AC converter 152 includes at least one three-phase valve bridge 152a.

The customer-side transformer part 160 includes, for the positive pole, at least one transformer 161 corresponding to the at least one three-phase valve bridge 151a and, for the negative pole, at least one transformer 162 corresponding to the at least one three-phase valve bridge 152a.

When one three-phase valve bridge 151a is used for the positive pole, the positive pole DC-AC converter 151 may generate an AC power having 6 pulses by using the positive pole DC power. Here, a primary coil and a secondary coil of one transformer 161 may have Y-Y connection or Y-Δ connection.

When two three-phase valve bridges 151a are used for the positive pole, the positive pole DC-AC converter 151 may generate an AC power having 12 pulses by using the positive pole DC power. Here, a primary coil and a secondary coil of one of the two transformers 161 may have Y-Y connection, and a primary coil and a secondary coil of the other of the two transformers 161 may have Y-Δ connection.

When three three-phase valve bridges 151a are used for the positive pole, the positive pole DC-AC converter 151 may generate an AC power having 18 pulses by using the positive pole DC power. The more the number of pulses of the AC power increases, the more the filter price may decrease.

When one three-phase valve bridge 152a is used for the negative pole, the negative pole DC-AC converter 152 may generate an AC power having 6 pulses by using the negative pole DC power. Here, a primary coil and a secondary coil of one transformer 162 may have Y-Y connection or Y-Δ connection.

When two three-phase valve bridges 152a is used for the negative pole, the negative pole DC-AC converter 152 may generate an AC power having 12 pulses by using the negative pole DC power. Here, a primary coil and a secondary coil of one of the two transformers 162 may have Y-Y connection, and a primary coil and a secondary coil of the other of the two transformers 162 may have Y-Δ connection.

When three three-phase valve bridges 152a is used for the negative pole, the negative pole DC-AC converter 152 may generate an AC power having 18 pulses by using the negative pole DC power. The more the number of pulses of the AC power increases, the more the filter price may decrease.

The customer-side AC part 170 includes an AC filter 171 and an AC power transmission line 173.

The AC filter 171 removes remaining frequency components except for a frequency component (for example, 60Hz) used by the customer part 180 from the AC power generated by the customer-side DC transformation part 105.

The AC power transmission line 173 transmits the filtered AC power to the customer part 180.

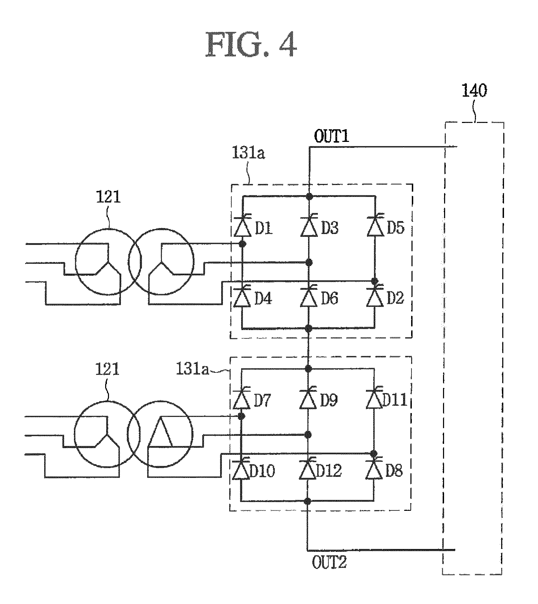

Fig. 4 is a view illustrating connection between the transformer and the three-phase valve bridge according to an embodiment.

Particularly, Fig. 4 illustrates the connection between the two transformers 121 for the positive pole and the two three-phase valve bridges 131a for the positive pole. Since the connection between the two transformers 122 for the negative pole and the two three-phase valve bridges 132a for the negative pole, the connection between the two transformers 161 for the positive pole and the two three-phase valve bridges 151a for the positive pole, the connection between the two transformers 162 for the negative pole and the two three-phase valve bridges 152a for the negative pole, the connection between the one transformer 121 for the positive pole and the one three-phase valve bridge 131a for the positive pole, and the connection between the one transformer 161 for the positive pole and the one three-phase valve bridge 151a for the positive pole could be easily derived from the embodiment of Fig. 4, their drawings and descriptions thereof will be omitted.

In Fig. 4, the transformer 121 having the Y-Y connection is called an upper transformer, the transformer 121 having the Y-Δ connection is called a lower transformer, the three-phase valve bridge 131a connected to the upper transformer is called an upper three-phase valve bridges, and the three-phase valve bridges 131a connected to the lower transformer is called a lower three-phase valve bridges.

The upper three-phase valve bridges and the lower three-phase valve bridges have two output terminals outputting a DC power, i.e., a first output terminal OUT1 and a second output terminal OUT2.

The upper three-phase valve bridge includes six valves D1 to D6, and the lower three-phase valve bridges include six valves D7 to D12.

The valve D1 has a cathode connected to the first output terminal OUT1 and an anode connected to a second terminal of the secondary coil of the upper transformer.

The valve D2 has a cathode connected to the anode of the valve D5 and an anode connected to the anode of the valve D6.

The valve D3 has a cathode connected to the first output terminal OUT1 and an anode connected to a second terminal of the secondary coil of the upper transformer.

The valve D4 has a cathode connected to the anode of the valve D1 and an anode connected to the anode of the valve D6.

The valve D5 has a cathode connected to the first output terminal OUT1 and an anode connected to a third terminal of the secondary coil of the upper transformer.

The valve D6 has a cathode connected to the anode of the valve D3.

The valve D7 has a cathode connected to the anode of the valve D6 and an anode connected to a first terminal of the secondary coil of the lower transformer.

The valve D8 has a cathode connected to the anode of the valve D11 and an anode connected to a second output terminal OUT2.

The valve D9 has a cathode connected to the anode of the valve D6 and an anode connected to a second terminal of the secondary coil of the lower transformer.

The valve D10 has a cathode connected to the anode of the valve D7 and an anode connected to the second output terminal OUT2.

The valve D11 has a cathode connected to the anode of the valve D6 and an anode connected to a third terminal of the secondary coil of the lower transformer.

The valve D12 has a cathode connected to the anode of the valve D9 and an anode connected to the second output terminal OUT2.

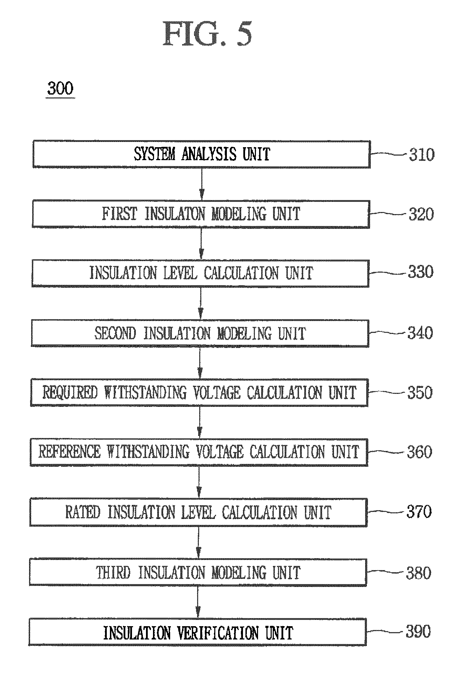

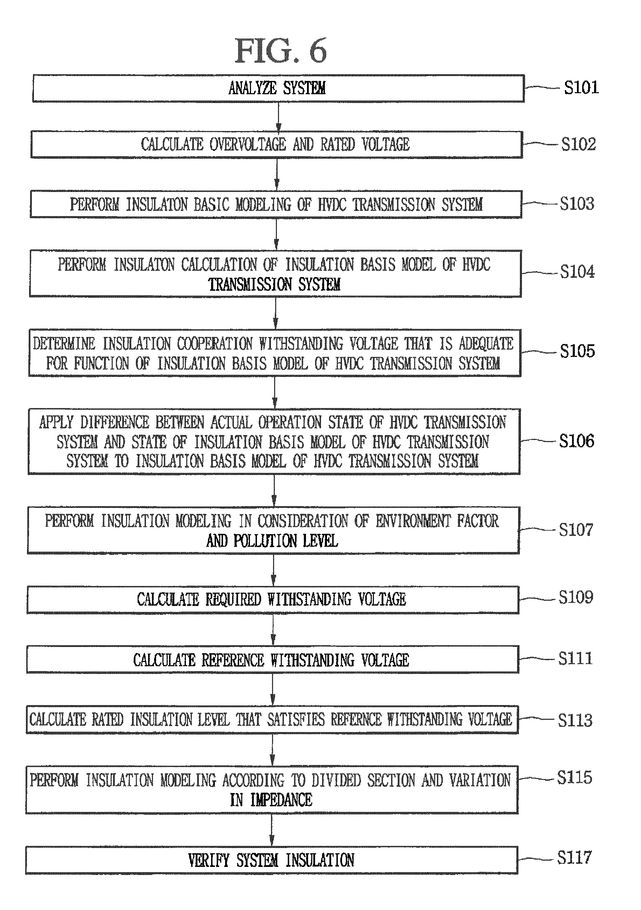

A method for an insulation design of the HVDC transmission system will be described with reference to Figs. 5 and 6.

Fig. 5 is a block diagram illustrating an apparatus for an insulation design of the HVDC transmission system according to an embodiment.

Referring to Fig. 5, an apparatus 30 for an insulation design of the HVDC transmission system 100 according to an embodiment includes a system analysis unit 310, a first insulation modeling unit 320, an insulation level calculation unit 330, a second insulation modeling unit 340, a required withstanding voltage calculation unit 350, a reference withstanding voltage calculation unit 360, a rated insulation level calculation unit 370, a third insulation modeling unit 380, and an insulation verification unit 390.

The system analysis unit 310 analyzes the HVDC transmission system 100 in operation S101 to calculate an overvoltage and rated voltage of the HVDC transmission system 100.

The first insulation modeling unit 320 may model the HVDC transmission system 100 on the basis of the calculated overvoltage and rated voltage to generate an insulation basis model of the HVDC transmission system 100.

The insulation level calculation unit 330 performs insulation calculation of the insulation basic model of the HVDC transmission system 100 in operation S104 to determine an insulation cooperation withstanding voltage that is adequate for performing a function of the insulation basic model of the HVDC transmission system 100.

The second insulation modeling unit 340 applies a difference between an actual operation state of the HVDC transmission system 100 and a state of the insulation basic model of the HVDC transmission system 100 to the insulation basic model of the HVDC transmission system 100 in operation S106 to correct the insulation basic model of the HVDC transmission system 100, thereby generating an insulation model of the HVDC transmission system 100.

The required withstanding voltage calculation unit 350 calculates a required withstanding voltage of the insulation model of the HVDC transmission system 100.

The reference withstanding voltage calculation unit 360 calculates a reference withstanding voltage of the insulation model of the HVDC transmission system 100 from the required withstanding voltage of the insulation model of the HVDC transmission system 100.

The rated insulation level calculation unit 370 calculates a rated insulation level that satisfies the reference withstanding voltage of the insulation model of the HVDC transmission system 100.

The third insulation modeling unit 380 corrects the insulation model of the HVDC transmission system 100 on the basis of a variation in impedance in a divided section of the HVDC transmission system 100 to generate a corrected insulation model.

The insulation verification unit 390 verifies whether the corrected insulation model of the HVDC transmission system 100 satisfies the required withstanding voltage.

Fig. 6 is a flowchart illustrating an operation method of the insulation design apparatus of the HVDC transmission system according to an embodiment.

The system analysis unit 310 analyzes the HVDC transmission system 100 in operation S101 to calculate an overvoltage and rated voltage in operation S102. The system analysis unit 310 may analyze the HVDC transmission system 100 to calculate the overvoltage and rated voltage on the basis of at least one of a classified stress voltage, a calculated overvoltage protection level, and an insulation property.

The first insulation modeling unit 320 models the HVDC transmission system 100 on the calculated overvoltage and rated voltage to generate an insulation basis model of the HVDC transmission system 100 in operation S103.

The insulation level calculation unit 330 performs insulation calculation of the insulation basic model of the HVDC transmission system 100 in operation S104 to determine an insulation cooperation withstanding voltage that is adequate for performing a function of the insulation basic model of the HVDC transmission system 100 in operation S105. Here, the insulation level calculation unit 330 performs insulation calculation of the insulation basic model of the HVDC transmission system 100 on the basis of at least one of an insulation property of the insulation basic model of the HVDC transmission system 100, a function of the insulation basic model of the HVDC transmission system 100, a statistical distribution of data of the insulation basic model of the HVDC transmission system 100, inaccuracy of input data of the insulation basic model of the HVDC transmission system 100, and a factor having an influence on an combination of components of the insulation basic model of the HVDC transmission system 100 to determine the insulation cooperation withstanding voltage that is adequate for performing the function of the insulation basis model of the HVDC transmission system 100.

The second insulation modeling unit 340 applies a difference between an actual operation state of the HVDC transmission system 100 and a state of the insulation basic model of the HVDC transmission system 100 to the insulation basic model of the HVDC transmission system 100 in operation S106 to correct the insulation basic model of the HVDC transmission system 100, thereby generating an insulation model of the HVDC transmission system 100 in operation S107. The second insulation modeling unit 340 may correct the insulation basic model of the HVDC transmission system 100 on the basis of a difference between an actual operation state of the HVDC transmission system 100 and the state of the insulation basic model of the HVDC transmission system 100 and the insulation cooperation withstanding voltage to generate an insulation model of the HVDC transmission system 100. Here, the difference between the actual operation state of the HVDC transmission system 100 and the state of the insulation basis model may include at least one of a difference in environment factor of the HVDC transmission system 100, a difference in test of the components of the HVDC transmission system 100, a deviation of a product characteristic of the HVDC transmission system 100, a difference in installation state of the HVDC transmission system 100, a difference in operation lifecycle of the HVDC transmission system 100, and a safety factor that has to be considered for safety of the HVDC transmission system 100. The insulation model of the HVDC transmission system 100 may be an insulation model that considers the environment factor and the pollution level.

The required withstanding voltage calculation unit 350 calculates a required withstanding voltage of the insulation model of the HVDC transmission system 100 in operation S109.

The reference withstanding voltage calculation unit 360 calculates a reference withstanding voltage of the insulation model of the HVDC transmission system 100 from the required withstanding voltage of the insulation model of the HVDC transmission system 100 in operation S111. The reference withstanding voltage calculation unit 360 may calculate a reference withstanding voltage of the insulation model of the HVDC transmission system 100 from the required withstanding voltage of the insulation model of the HVDC transmission system 100 on the basis of at least one of a test state, a test conversion factor, and a voltage range.

The rated insulation level calculation unit 370 calculates a rated insulation level that satisfies the reference withstanding voltage of the insulation model of the HVDC transmission system 100 in operation S113. Here, the rated insulation level may include a voltage value and distance value at at least one position of the HVDC transmission system 100.

The third insulation modeling unit 380 corrects the insulation model of the HVDC transmission system 100 on the basis of a variation in impedance in a divided section of the HVDC transmission system 100 to generate a corrected insulation model in operation S115. Here, the divided section may include at least one of a transmission-side AC part 110, a transmission-side transformation part 103, a DC power transmission part 140, a customer-side transformation part 105, a customer-side AC part 170, a transmission-side transformer part 120, a transmission-side AC-DC converter part 130, a customer-side DC-AC converter part 150, and a customer-side transformer part 160.

The insulation verification unit 390 verifies whether the corrected insulation model of the HVDC transmission system 100 satisfies the required withstanding voltage in operation S117.

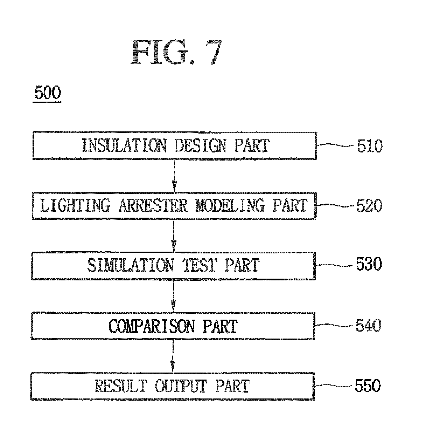

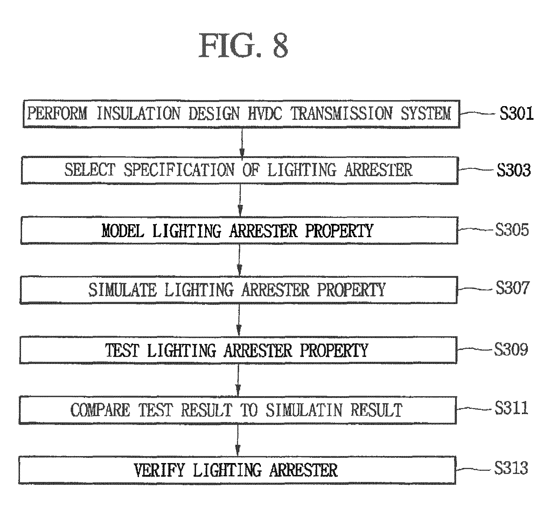

A method for verifying the lighting arrester of the HVDC transmission system will be described with reference to Figs. 7 and 8.

Fig. 7 is a block diagram of an apparatus for verifying a lighting arrester of the HVDC transmission system according to an embodiment.

The apparatus 500 for verifying the lighting arrester includes an insulation design part 510, a lighting arrester modeling part 520, a simulation test part 530, a comparison part 540, and a result output part 550.

The insulation design part 510 generates an insulation model of the HVDC transmission system 100.

The lighting arrester modeling part 520 generates a lighting arrester model that satisfies a specification of a selected lighting arrester.

The simulation test part 530 may perform a simulation test of the lighting arrester model in the insulation model of the HVDC transmission system 100 to output a lighting arrester simulation test result.

The comparison part 540 compares a lighting arrester property test result to the lighting arrester simulation test result to check whether the lighting arrester property test result is satisfied within an allowable range of the lighting arrester simulation test result.

The result output part 550 outputs the verified result of the lighting arrester.

Fig. 8 is a flowchart illustrating an operation method of the apparatus for verifying the lighting arrester of the HVDC transmission system according to an embodiment.

In operation S301, the insulation design part 510 generates an insulation model of the HVDC transmission system 100. The insulation design part 510 may include the components of Fig. 5, and may generate an insulation model as illustrated in Fig. 6. As described, the insulation design part 510 may generate the insulation model of the HVDC transmission system 100 on the basis of at least one of stress voltage classification, overvoltage protection level calculation, an insulation property, statistic distribution, an environment factor, an operation lifecycle, an safety factor, an insulation cooperation withstanding voltage, a reference withstanding voltage, and a rated insulation level.

In operation S303, the lighting arrester modeling part 520 acquires user information for selecting a specification of the lighting arrester within the insulation model of the HVDC transmission system 100.

In operation S305, the lighting arrester modeling part 520 generates a lighting arrester model that satisfies a specification of a selected lighting arrester. The lighting arrester modeling part 520 may generate the lighting arrester model that satisfies the specification of the selected lighting arrester on the basis of at least one lighting arrester property such as a lightning impulse, a switching impulse, a fast front wave impulse, a slow front wave impulse, and a temporary over voltage.

In operation S307, the simulation test part 530 may perform a simulation test of the lighting arrester model in the insulation model of the HVDC transmission system 100 to output a lighting arrester simulation test result.

In operation S309, the comparison part 540 acquires a lighting arrester property test result. Here, the lighting arrester property test result may include at least one lighting arrester property test result such as insulation resistance, leakage current, an operation firing voltage, a lighting restriction voltage, long-time impact current, partial discharge, a lighting withstanding voltage, and an high current operation.

In operation S311, the comparison part 540 compares a lighting arrester property test result to the lighting arrester simulation test result to check whether the lighting arrester property test result is satisfied within an allowable range of the lighting arrester simulation test result.

In operation S313, the result output part 550 outputs the verified result of the lighting arrester on the basis of the comparison between the lighting arrester property test result to the lighting arrester simulation test result. If the lighting arrester property test result is satisfied within an allowable range of the lighting arrester simulation test result, the result output part 550 may output a positive result. If the lighting arrester property test result is not satisfied within an allowable range of the lighting arrester simulation test result, the result output part 550 may output a negative result.

According to the embodiment, the verification of the lighting arrester in consideration of the design value of the HVDC transmission system may be performed by modeling the lighting arrester properties.

According to the embodiment, the cumbersome process for redesigning the lighting arrester for each section and voltage fluctuation may be reduced.

According to the embodiment, the above-described method can also be embodied as processor readable codes on a processor readable recording medium. Examples of the processor readable recording medium include read-only memory (ROM), random-access memory (RAM), CD-ROMs, magnetic tapes, floppy disks, optical data storage devices, and carrier waves (such as data transmission through the Internet).

Also, the embodiments set forth therein is not so limitedly, but all or part of the embodiments can be selectively combined so as to derive many variations.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. An apparatus for an insulation design, which performs the insulation design of a high voltage direct current (HVDC) transmission system, the apparatus comprising:
an insulation design part (510) generating an insulation model of the HVDC transmission system;
a lighting arrester modeling part (520) generating a lighting arrester model that satisfies a specification of a lighting arrester selected for the lighting arrester within the insulation model of the HVDC transmission system;
a simulation test part (530) performing a simulation test of the lighting arrester model in the insulation model of the HVDC transmission system to output a lighting arrester simulation test result;
a comparison part (540) acquiring a lighting arrester property test result and comparing the lighting arrester property test result to the lighting arrester simulation test result; and
a result output part (550) outputting a verification result of the lighting arrester on the basis of the comparison between the lighting arrester property test result and the lighting arrester simulation test result.

2. The apparatus according to claim 1, wherein the lighting arrester modeling part (520) generates the lighting arrester model that satisfies the specification of the selected lighting arrester on the basis of at least one of a lightning impulse, a switching impulse, a fast front wave impulse, a slow front wave impulse, and a temporary over voltage.

3. The apparatus according to claim 1, wherein the lighting arrester property test result comprises at least one test result of insulation resistance, leakage current, an operation firing voltage, a lighting restriction voltage, long-time impact current, partial discharge, a lighting withstanding voltage, and an high current operation.

4. The apparatus according to claim 1, wherein, if the lighting arrester property test result is satisfied within an allowable range of the lighting arrester simulation test result, the result output part (550) outputs a positive result, and
if the lighting arrester property test result is not satisfied within an allowable range of the lighting arrester simulation test result, the result output part (550) outputs a negative result.

5. The apparatus according to claim 1, wherein the insulation design part (510) comprises:
a first insulation modeling unit (320) modeling the HVDC transmission system on the basis of an overvoltage and rated voltage of the HVDC transmission system to generate an insulation basis model of the HVDC transmission system;
an insulation level calculation unit (330) performing insulation calculation of the insulation basic model to determine an insulation cooperation withstanding voltage that is adequate for performing a function of the insulation basis model of the HVDC transmission system; and
a second insulation modeling unit (340) correcting the insulation basis model of the HVDC transmission system on the basis of the insulation cooperation withstanding voltage to generate an insulation model of the HVDC transmission system.

6. The apparatus according to claim 5, wherein the insulation design part (510) further comprises:
a rated insulation level calculation unit (370) calculating a rated insulation level that satisfies a reference withstanding voltage of the insulation model of the HVDC transmission system
a third insulation modeling unit (380) correcting the insulation model of the HVDC transmission system on the basis of a variation in impedance in a divided section of the HVDC transmission system to generate a corrected insulation model; and
an insulation verification unit (390) verifying whether the corrected insulation model of the HVDC transmission system satisfies the required withstanding voltage.

7. The apparatus according to claim 6, wherein the divided section of the HVDC transmission system comprises at least one of a transmission-side AC part, a transmission-side transformation part, a DC power transmission part, a customer-side transformation part, a customer-side AC part, a transmission-side transformer part, a transmission-side AC-DC converter part, a customer-side DC-AC converter part, and a customer-side transformer part.

8. The apparatus according to claim 5, wherein the second insulation modeling unit (340) corrects the insulation basis model of the HVDC transmission system on the basis of a difference between an actual operation state of the HVDC transmission system and a state of the insulation basis model of the HVDC transmission system and the insulation cooperation withstanding voltage to generate an insulation model of the HVDC transmission system.
